# EUROPÄISCHE PATENTSCHRIFT

(11) **EP 3 496 166 B1**
(45) Veröffentlichungstag und Bekanntmachung des Hinweises auf die Patenterteilung: **10.06.2020**
(21) Anmeldenummer: 18209700.6
(22) Anmeldetag: 09.04.2013
(51) Int. Cl.: H01L 39/14

(54) **NBTI-SUPRALEITER MIT REDUZIERTEM GEWICHT**
NBTI SUPERCONDUCTOR WITH REDUCED WEIGHT
SUPRACONDUCTEUR NBTI AYANT UN POIDS RÉDUIT

(30) Priorität: 11.04.2012 DE 102012205843
(43) Veröffentlichungstag der Anmeldung: 12.06.2019
(62) Teilanmeldung aus: 13162850.5
(73) Patentinhaber: Bruker EAS GmbH, 63450 Hanau (DE)
(72) Erfinder: Szulzcyk, Andreas, 63589 Linsengericht (DE)
(74) Vertreter: Kohler Schmid Möbus Patentanwälte

(56) Entgegenhaltungen:
- EP-A1- 2 278 595
- DE-U1-202012 102 334
- JP-A- 2001 014 959
- US-A- 4 506 109

## Beschreibung

Die Erfindung betrifft einen Supraleiterdraht, enthaltend NbTi-Supraleitermaterial und Cu,
umfassend eine Vielzahl von Hexagonalelementen, die im Querschnitt senkrecht zur Erstreckungsrichtung des Supraleiterdrahtes eine zumindest näherungsweise hexagonale Außenkontur aufweisen.

Eine solcher Supraleiterdraht ist bekannt geworden durch die US 5,088,183 A.

Niobtitan (NbTi) ist ein wichtiges Supraleitermaterial, welches aufgrund seiner guten plastischen Verformbarkeit (sowohl im Fertigmaterial als auch bezüglich Precursoren) vielseitig eingesetzt werden kann, beispielsweise in supraleitenden Magnetspulen oder supraleitenden Kabeln. Das NbTi-Supraleitermaterial ist dabei typischerweise in einen Supraleiterdraht integriert, wobei meist eine Vielzahl von NbTi-Filamenten entlang der Erstreckungsrichtung des Supraleiterdrahtes verlaufen.

Im Rahmen der Drahtherstellung ist es oftmals vorgesehen, zur Vereinfachung von Bündelungsprozessen bei NbTi-Einzelfilamenten (oder auch anderen Strukturen und Zwischenstrukturen) zunächst im Rahmen eines Ziehprozesses eine plastische Verformung zu einem hexagonalen Außenquerschnitt vorzunehmen. Die entstehenden Hexagonalelemente können dann sehr kompakt beispielsweise in einem Cu-Hüllrohr angeordnet werden, vgl. die eingangs erwähnte US 5,088,183 A.

Die supraleitenden Eigenschaften von NbTi werden nur bei besonders tiefer Temperatur, unterhalb von ca. 9 K, erreicht, so dass der Supraleiter gekühlt werden muss, etwa mit flüssigem Helium. Ebenso wird der supraleitende Zustand bei zu hoher Magnetfeldstärke oder auch zu hoher Stromdichte nicht mehr aufrecht erhalten.

NbTi-Supraleiterdrähte sind typischerweise mit Kupfer (Cu), meist in hohen Reinheitsgraden, stabilisiert. Das Kupfer verlauft parallel zu supraleitenden Filamenten im Supraleiterdraht; beispielsweise kann das Kupfer eine Matrix für supraleitende NbTi-Filamente ausbilden. Das Kupfer stellt einen guten Wärmeleiter dar, über das eine effektive Kühlung der supraleitenden NbTi-Filamente erfolgen kann. Weiterhin hat das Kupfer eine hohe elektrische Leitfähigkeit. Im Falle eines lokalen Verlusts der Supraleitung im Supraleiterdraht stellt das Kupfer einen parallelen Strompfad zur Verfügung, wodurch ein Anstieg des elektrischen Widerstands und auch eine zugehörige Wärmeentwicklung begrenzt wird. Durch die effektive Kühlung kann der lokale normalleitende Bereich im Supraleiter schließlich wieder supraleitend werden (Stabilisierungsfunktion). Auch wenn eine Wiedergewinnung der Supraleitung nicht möglich ist, schützt das Kupfer vor einer Beschädigung ("Durchbrennen") des Supraleiters durch Begrenzung der Widerstandsanstiegs und dadurch Begrenzung der Wärmeentwicklung, und gleichzeitig effizienten Abtransport der entstehenden Wärme (Quenchschutz). Das Kupfer verbessert außerdem die mechanische Festigkeit des Supraleiterdrahts.

Kupfer ist zum einen ein teures Material, und zum anderen mit einer Dichte von ca. 8,9 g/cm³ relativ schwer, was bei vielen Anwendungen unerwünscht ist. Daher wird nach alternativen Materialien zur Stabilisierung von NbTi-Supraleitern gesucht, die das Kupfer zumindest teilweise ersetzen können. Aluminium (Al) in reiner Form wäre bezüglich Wärmeleitung und elektrischem Widerstand ein geeignetes Material, welches billiger als Kupfer und mit einer Dichte von 2,7 g/cm³ deutlich leichter ist.

In der WO 2008/121764 A1 wurde eine NbTi-Supraleiterstruktur mit einer Cu-Hülse, einem AI-Kern und ringförmig dazwischen angeordneten Multifilament-NbTi-Stäben vorgeschlagen.

Während Cu und NbTi beide relativ hart sind und sich bei plastischer Verformung ähnlich verhalten, ist Al im Vergleich zu NbTi und Cu deutlich weicher. Beim Drahtziehen wurden beim Einsatz von Al-Strukturen, insbesondere eines Al-Kerns, in einem NbTi-Supraleiterdraht Risse quer zur Erstreckungsrichtung des Drahtes beobachtet. Ein rissbehafteter Draht ist für Supraleiteranwendung unbrauchbar.

Aus der US 5,189,386 ist eine Supraleiterstruktur bekannt geworden, bei der ein Al-Kern durch Schichten aus einer Cu-Ni-Legierung in sechs Sektoren unterteilt ist. Diese Struktur ist relativ komplex.

In der US 4,652,697 ist eine Supraleiterstruktur beschrieben, bei der drei Al-Drähte und vier Multifilamentdrähte, beispielsweise mit NbTi-Filamenten und einer Kupfermatrix, gebündelt wurden. Einer der Multifilamentdrähte ist im Zentrum der Supraleiterstruktur angeordnet. Die Struktur wird von einem PbSn-Lot zusammengehalten. Ein Lot ist bei der Drahtherstellung schwierig zu verarbeiten und kann als weiteres Material die Rissbildungsproblematik zusätzlich verschärfen.

Die US 4,506,109 A beschreibt NbTi-Supraleiterdrähte, bestehend aus einer Vielzahl von Elementen mit rundem oder anderem Querschnitt. Supraleiterelemente sind alternierend mit Aluminiumelementen um einen Kern angeordnet. Die Struktur wird analog zur US 4,652,697 von einem PbSn-Lot zusammengehalten.

Die JP 09 282953 A beschreibt einen Nb₃Al-Supraleiterdraht, bei dem Nb₃Al-Filamente in eine Kupfermatrix eingebunden sind. Zur Verstärkung können eingebettete Zusatzstrukturen etwa aus Nb oder Ta vorgesehen sein. In einer Ausführungsform werden Zusatzstrukturen mit einem AI-Stab in einem Cu-Rohr vorgeschlagen.

Aus der EP 2 278 595 A1 ist ein NbTi-Supraleiter mit CuMn-Cu-Matrix bekannt geworden, der eine Vielzahl von Sechskantelementen im Leitungsquerschnitt aufweist. Dabei ist eine Mehrzahl von Cu-Strukturen zwischen den CuMn-Kernleitelementen verteilt angeordnet, um eine gute Stabilisierung zu gewährleisten.

Die JP 2001 014 959 A beschreibt eine Supraleiterstruktur, bestehend aus Bündeln mehreren supraleitender Stränge. Die supraleitenden Stränge weisen dabei zwei supraleitende Drähte sowie einen mit CuNi umhüllten Aluminiumdraht zur Stabilisierung auf.

### Aufgabe der Erfindung

Der Erfindung liegt die Aufgabe zugrunde, einen stabilisierten NbTi-Supraleiterdraht vorzuschlagen, der ein geringes Gewicht aufweist, und bei dessen Herstellung, insbesondere beim Drahtziehen, die Gefahr einer Rissbildung vermindert ist.

### Kurze Beschreibung der Erfindung

Diese Aufgabe wird gelöst durch einen Supraleiterdraht der eingangs genannten Art, der dadurch gekennzeichnet ist, dass zumindest ein Teil der Hexagonalelemente als Cu-Al-Verbundelemente ausgebildet ist, wobei die Cu-Al-Verbundelemente im Querschnitt senkrecht zur Erstreckungsrichtung des Supraleiterdrahtes jeweils ausgebildet sind mit einem Al-Kern und einem Cu-Mantel, der den Al-Kern umhüllt, und dass der Supraleiterdraht eine Hülse, insbesondere Cu-Hülse, aufweist, in die mehrere voneinander separate NbTi-Unterstrukturen eingebettet sind, wobei jede NbTi-Unterstruktur ein oder mehrere NbTi-Filamente aufweist.

Die Erfindung schlägt vor, Kupfer für die Stabilisierung des NbTi-Supraleitermaterials teilweise durch Aluminium zu ersetzen, wobei ein besonderer Hybridaufbau vorgeschlagen wird, welcher bei plastischen Verformungsprozessen, wie sie beim Drahtziehen eines NbTi-Supraleiterdrahtes auftreten, umformtechnisch besonders geeignet ist und einer Rissbildung vorbeugt bzw. eine Rissbildung vermeidet.

Gemäß der Erfindung wird das Aluminium in Cu-Al-Verbundelemente eingebracht, bei denen jeweils das Aluminium einen Kern ausbildet, und Kupfer den AI-Kern (im Querschnitt senkrecht zur Erstreckungsrichtung/Längsrichtung des Drahtes) vollständig umgibt. Die Cu-Al-Verbundelemente können auch als Cu-kaschierte Al-Elemente bezeichnet werden. Die Cu-Al-Verbundelemente werden im erfindungsgemäßen Supraleiterdraht verbaut.

Die AI-Kerne der Cu-Al-Verbundelemente sind zumindest durch die sie umgebenden Cu-Mäntel (Cu-Kaschierungen) voneinander getrennt, so dass nur jeweils relativ kleine zusammenhängende Kontaktflächen von AI und Cu ausgebildet werden. Dadurch werden die lokalen mechanischen Spannungen, welche beim Umformen (insbesondere Drahtziehen) an den Cu/Al-Grenzflächen auftreten, begrenzt. Die Kontaktfläche zwischen AI und Cu wird erfindungsgemäß auf viele Cu-Al-Verbundelemente verteilt. Weiterhin ist ein direkter Kontakt von Al-Kernen und NbTi-Strukturen ausgeschlossen, so dass Al/NbTi-Grenzflächen als Quelle von mechanischen Spannungen beim Umformen entfallen.

Durch die Verwendung einer Vielzahl von Cu-Al-Verbundelementen im erfindungsgemäßen Supraleiterdraht kann das Metergewicht (also die Masse des Supraleiterdrahtes pro Länge in Erstreckungsrichtung) gegenüber der ausschließlichen Verwendung von Kupfer zur Stabilisierung des Supraleitermaterials deutlich reduziert werden.

Durch die hexagonale Ausbildung der Cu-Al-Verbundelemente können diese leicht in einen erfindungsgemäßen Supraleiterdraht integriert werden. Die hexagonalen Cu-Al-Verbundelemente können dabei sehr kompakt (typischerweise in Bündeln) angeordnet werden; insbesondere werden Hohlräume in der Umgebung von Cu-Al-Verbundelementen vermieden. Dadurch besteht eine besonders hohe Kontrolle über den Umformprozess, so dass die Cu-Kaschierungen um die AI-Kerne im Rahmen von Drahtziehprozessen in der Regel gut erhalten werden können.

Die Erfindung sieht vor, dass der Supraleiterdraht eine Hülse, insbesondere Cu-Hülse, aufweist, in die mehrere voneinander separate NbTi-Unterstrukturen eingebettet sind, wobei jede NbTi-Unterstruktur ein oder mehrere NbTi-Filamente aufweist. Die NbTi-Unterstrukturen können insbesondere einen runden Querschnitt aufweisen. Die Hülse dient als Matrix für die NbTi-Unterstrukturen. Dieser Aufbau ist mechanisch besonders stabil.

Der erfindungsgemäße Supraleiterdraht umfasst typischerweise mindestens 7, bevorzugt mindestens 19, besonders bevorzugt mindestens 85 Cu-Al-Verbundelemente. Die Querschnittsfläche eines erfindungsgemäßen Supraleiterdrahts wird typischerweise zu wenigstens 15%, bevorzugt wenigstens 25%, besonders bevorzugt wenigstens 35%, von Cu-Al-Verbundelementen eingenommen.

Das Aluminium (Al) der Cu-Al-Verbundelemente ist typischerweise von hoher Reinheit (bevorzugt > 99 Gew % Al); dabei können Spurendotierungen im Al (etwa zur Einstellung der elektrischen und thermischen Eigenschaften) enthalten sein, falls gewünscht. Das Kupfer (Cu) in den Cu-Al-Verbundelementen, und typischerweise auch im übrigen Supraleiterdraht, ist bevorzugt ebenfalls von hoher Reinheit (bevorzugt > 99 Gew% Cu), kann aber auch in einer kupferhaltigen Legierung vorliegen (bevorzugt ≥ 80 Gew% Cu, besonders bevorzugt ≥ 90 Gew% Cu in der Cu-Legierung).

Bevorzugt besteht ein Cu-Al-Verbundelement im Rahmen der Erfindung bevorzugt zu ca. 10-20 Vol% aus Kuper (oder einer kupferhaltigen Legierung), und zu ca. 80-90 Vol% aus Aluminium.

Man beachte, das die Al-Kerne in den Cu-Al-Verbundelementen im Querschnitt senkrecht zur Erstreckungsrichtung des Supraleiterdrahtes typischerweise ebenfalls eine näherungsweise hexagonale Kontur haben. Der erfindungsgemäße Supraleiterdraht insgesamt hat typischerweise einen näherungsweise kreisrunden Querschnitt, kann aber auch eine andere Kontur haben, beispielsweise eine hexagonale Kontur.

### Bevorzugte Ausführungsformen der Erfindung

Bei einer vorteilhaften Ausführungsform eines erfindungsgemäßen Supraleiterdrahts ist vorgesehen, dass der Supraleiterdraht im Querschnitt senkrecht zur Erstreckungsrichtung des Supraleiterdrahtes zumindest drei Cu-Al-Sektoren aufweist, wobei jeder Cu-Al-Sektor eine Vielzahl von aneinander grenzenden Cu-Al-Verbundelementen aufweist, und wobei die Cu-Al-Sektoren azimutal voneinander beabstandet sind, insbesondere wobei die Cu-Al-Sektoren azimutal gleichmäßig verteilt angeordnet sind. Die Cu-Al-Sektoren werden in azimutaler Richtung typischerweise durch NbTi-Elemente (siehe unten) voneinander getrennt. Durch die azimutale Beabstandung der Sektoren werden spannungsarme Bereiche im Supraleiterdraht eingerichtet, die einer Rissbildung vorbeugen. Insbesondere können sich mechanische Spannungen infolge von Umformprozessen entlang der azimutaler Richtung (Umfangsrichtung des Drahtes) nur über kurze Strecken aufbauen.

Bevorzugt ist eine Weiterbildung dieser Ausführungsform, bei der die zumindest drei Cu-Al-Sektoren an einen Cu-Al-Zentralsektor angrenzen, der eine Vielzahl von aneinander grenzenden Cu-Al-Verbundelementen aufweist und der im Querschnitt senkrecht zur Erstreckungsrichtung des Supraleiterdrahtes im Zentrum des Supraleiterdrahtes angeordnet ist. Durch eine Nutzung des Zentrums des Supraleiterdrahtes für einen Cu-Al-Zentralsektor steht weitere Querschnittsfläche für die Nutzung von Al anstelle von Cu zur Verfügung.

Ebenfalls vorteilhaft ist eine Ausführungsform, die vorsieht, dass der Supraleiterdraht im Querschnitt senkrecht zur Erstreckungsrichtung des Supraleiterdrahtes wenigstens drei voneinander separate Cu-Al-Cluster aufweist, wobei jeder Cu-Al-Cluster eine Vielzahl von aneinander grenzenden Cu-Al-Verbundelementen aufweist. Die Cu-Al-Cluster grenzen im Querschnitt nicht aneinander; sie sind typischerweise durch NbTi-Elemente und/oder durch ein Profilrohr (siehe unten) voneinander getrennt. Durch die Separierung der Cu-Al-Cluster werden spannungsarme Bereiche im Supraleiterdraht eingerichtet, die einer Rissbildung vorbeugen. Insbesondere können sich mechanische Spannungen infolge von Umformprozessen nur über kurze Strecken aufbauen.

Besonders bevorzugt ist eine Ausführungsform, bei der ein Teil der Hexagonalelemente als NbTi-Elemente ausgebildet ist, wobei die NbTi-Elemente jeweils ein oder mehrere NbTi-Filamente aufweisen. Die NbTi-Elemente können leicht gehandhabt und insbesondere sehr kompakt im Supraleiterdraht angeordnet werden, insbesondere auch zusammen mit den Cu-Al-Verbundelementen. Die NbTi-Elemente sind regelmäßig aluminiumfrei. Man beachte, dass bei mehrstufigen Bündel- und Ziehprozessen Hexagonalelemente ihrerseits Hexagonalelemente enthalten können.

In einer bevorzugten Weiterbildung weisen die NbTi-Elemente jeweils eine Cu-Matrix und/oder eine Cu-Hülle auf. Die Cu-Matrix oder Cu-Hülle stabilisiert das oder die NbTi-Filamente bezüglich der Supraleitung; bei Umformprozessen sind aufgrund der ähnlichen Materialeigenschaften von Cu und NbTi keine Schwierigkeiten (insbesondere keine Risse) zu erwarten. Die Cu-Matrix bzw. Cu-Hülle bewirkt auch eine gewisse mechanische Stabilisierung..

Bei einer anderen Weiterbildung ist vorgesehen, dass der Supraleiterdraht im Querschnitt senkrecht zur Erstreckungsrichtung des Supraleiterdrahtes wenigstens drei NbTi-Sektoren aufweist, wobei jeder NbTi-Sektor eine Vielzahl von aneinander grenzenden NbTi-Elementen aufweist, und wobei die NbTi-Sektoren azimutal voneinander beabstandet sind. Die NbTi-Sektoren werden in azimutaler Richtung (Umfangsrichtung des Drahtes) typischerweise durch Cu-Al-Verbundelemente voneinander getrennt. Durch die NbTi-Sektoren können ausgedehnte Bereiche eingerichtet werden, in denen auch nach einem Umformprozess keine nennenswerten mechanischen Spannungen auftreten. Dadurch werden insgesamt die Spannungen im Supraleiterdraht begrenzt.

Bevorzugt ist auch eine Ausführungsform, bei der der Supraleiterdraht im Querschnitt senkrecht zur Erstreckungsrichtung des Supraleiterdrahtes einen Zentralbereich aufweist, der AI enthält. Durch eine Nutzung des Zentralbereichs des Supraleiterdrahtes für einen Cu-Al-Zentralsektor steht weitere Querschnittsfläche für die Nutzung von AI anstelle von Cu zur Verfügung.

Vorteilhaft ist dabei eine Weiterbildung, bei der der Zentralbereich eine Vielzahl von aneinander angrenzenden Cu-Al-Verbundelementen aufweist. Durch die Verwendung der Cu-Al-Verbundelemente werden mechanische Spannungen nach Umformprozessen im Zentralbereich begrenzt.

Bevorzugt ist auch eine Weiterbildung, bei der ein Profilrohr, insbesondere ein Cu-Profilrohr, den Zentralbereich begrenzt. Das Profilrohr weist im Querschnitt innenseitig und/oder außenseitig Konturen zur Anlage von Hexagonalelementen auf. Im Inneren des Profilrohrs kann ein Cu-Al-Zentralcluster aus aneinander grenzenden Cu-Al-Verbundelementen angeordnet sein. Durch das Profilrohr wird eine mechanische Stabilisierung des Supraleiterdrahts ermöglicht; auch kann dadurch das Zusammenfügen des Supraleiterdrahts erleichtert werden.

Bevorzugt ist dabei eine Ausführungsform, die vorsieht, dass die NbTi-Unterstrukturen azimutal gleichmäßig verteilt angeordnet sind. Weiterhin kann vorgesehen sein, dass die NbTi-Unterstrukturen einen gleichen radialen Abstand zum Zentrum des Supraleiterdrahtes haben. Alternativ kann auch vorgesehen sein, dass die NbTi-Unterstrukturen auf zwei oder mehr radiale Abstände verteilt sind, wobei jeweils sechs oder mehr NbTi-Unterstrukturen den gleichen radialen Abstand zum Zentrum des Supraleiterdrahts haben. Durch einen symmetrischen Aufbau ist die Supraleitung besonders stabil.

Schließlich ist noch eine Ausführungsform bevorzugt, bei der der Supraleiterdraht ein äußeres Hüllrohr umfasst, insbesondere ein Cu-Hüllrohr. Das Hüllrohr kann den Supraleiterdraht mechanisch gut stabilisieren. Im Hüllrohr können auch auf einfache Weise ein oder mehrere Bündel von Hexagonalelementen angeordnet werden.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: eine schematische Darstellung der Herstellung eines Cu-Al-Verbundelements (gezeigt im Querschnitt senkrecht zur Erstreckungsrichtung) für die Erfindung;
- Fig. 2: eine schematische Darstellung der Herstellung von NbTi-Elementen (gezeigt im Querschnitt senkrecht zur Erstreckungsrichtung) für die Erfindung;
- Fig. 3: einen schematischen Querschnitt (senkrecht zur Erstreckungsrichtung) durch eine Bauform eines Supraleiterdrahtes zur allgemeinen Erläuterung, mit einer zufälligen Mischung von Cu-Al-Verbundelementen und NbTi-Elementen;
- Fig. 4: einen schematischen Querschnitt (senkrecht zur Erstreckungsrichtung) durch eine weitere Bauform eines Supraleiterdrahtes zur allgemeinen Erläuterung, mit vier separaten Cu-Al-Clustern;
- Fig. 5: einen schematischen Querschnitt (senkrecht zur Erstreckungsrichtung) durch eine weitere Bauform eines Supraleiterdrahtes zur allgemeinen Erläuterung, mit fünf separaten Cu-Al-Clustern einschließlich eines Cu-Al-Clusters im Zentralbereich des Supraleiterdrahtes;
- Fig. 6: einen schematischen Querschnitt (senkrecht zur Erstreckungsrichtung) durch eine weitere Bauform eines Supraleiterdrahtes zur allgemeinen Erläuterung, mit vier azimutal separierten Cu-Al-Sektoren und einem diese verbindenden Cu-Al-Zentralsektor;
- Fig. 7: einen schematischen Querschnitt (senkrecht zur Erstreckungsrichtung) durch eine weitere Bauform eines Supraleiterdrahtes zur allgemeinen Erläuterung, mit vier separaten Cu-Al-Clustern und einem Cu-Profilrohr, welches einen Zentralbereich des Supraleiterdrahtes begrenzt und in welchem ein Al-Kern enthalten ist;
- Fig. 8: einen schematischen Querschnitt (senkrecht zur Erstreckungsrichtung) durch eine weitere Bauform eines Supraleiterdrahtes zur allgemeinen Erläuterung, mit einem außen und innen profilierten Cu-Profilrohr, welches Cu-Al-Verbundelemente enthält;
- Fig. 9: einen schematischen Querschnitt (senkrecht zur Erstreckungsrichtung) durch eine weitere Bauform eines Supraleiterdrahtes zur allgemeinen Erläuterung, mit einer Vielzahl von aneinander grenzenden Cu-Al-Verbundelementen in einem Zentralbereich;
- Fig. 10: einen schematischen Querschnitt (senkrecht zur Erstreckungsrichtung) durch eine erste Ausführungsform eines erfindungsgemäßen Supraleiterdrahtes, mit einer Cu-Hülse, in welche NbTi-Unterstrukturen jeweils auf gleichem Radius eingebettet sind;
- Fig. 11: einen schematischen Querschnitt (senkrecht zur Erstreckungsrichtung) durch eine zweite Ausführungsform eines erfindungsgemäßen Supraleiterdrahtes, mit einer Cu-Hülse, in welche NbTi-Unterstrukturen auf zwei verschiedenen Radien eingebettet sind.

### Überblick über die Erfindung

Die vorliegende Erfindung schlägt vor, Aluminium in einen NbTi-Supraleiterdraht zu integrieren, indem das AI in kupferkaschierten AI-Stäben, auch Cu-Al-Verbundelement genannt, eingebracht wird. Dadurch kann können mechanische Spannungen bei Kaltverformung bzw. beim Drahtziehen, die aufgrund von unterschiedlichem Formänderungswiderstand von weichem Al einerseits und hartem NbTi und Cu anderseits auftreten, zumindest teilweise aufgefangen bzw. ausgeglichen werden. Im erfindungsgemäßen Aufbau des Supraleiterdrahtes wechselt sich hartes und weiches Material häufig ab (insbesondere in Umfangsrichtung des Drahts), und große (insbesondere voll umlaufende) Kontaktflächen zwischen hartem Cu (und NbTi) einerseits und Al andererseits werden vermieden.

Im Rahmen der Erfindung können praktisch beliebige Mengen von NbTi-Filamenten in einen Supraleiterdraht integriert werden, ohne dass eine Rissbildung im Rahmen von kalten Verformungsprozessen (etwa beim Drahtziehen) provoziert würde. Dies ist besonders wichtig, weil mit NbTi-AI-Verbundmaterial eine Optimierungswärmebehandlung (etwa bei 350-400°C) nicht möglich ist, da bei den zugehörigen Temperaturen Rekristallisationsprozesse einsetzen bzw. intermetallische Phasen entstehen, die die Supraleitfähigkeit beeinträchtigen. Hingegen kann durch eine Kaltverformung bzw. ein Drahtziehen regelmäßig die Stromtragfähigkeit verbessert werden (sog. APC-Material, APC=artificial pinning center). Im Rahmen der Erfindung wird bevorzugt NbTi-APC-Material eingesetzt.

Aluminium weist ein geringes spezifisches Gewicht auf, so dass der Ersatz von Cu durch Al Gewicht im Supraleiterdraht einspart, was vor allem bei größeren Strukturen (etwa Stromleitungen für Offshore-Windkraftparks) geschätzt wird. Zudem besitzt Aluminium eine gute elektrische Leitfähigkeit und stellt somit einen guten (niedrigohmigen) Shuntwiderstand bereit. Mit AI sind hohe Restwiderstandsverhältnisse (RRR-Werte) möglich, bei hoher Reinheit des Aluminiums um ca. 3000-5000, was deutlich über den mit Cu erreichbaren RRR-Werten von ca. 100-400 liegt.

Bevorzugt wird Cu im Rahmen der Erfindung nicht vollständig, sondern nur teilweise durch Al ersetzt, so dass das verbleibende Kupfer noch zu einer guten mechanischen Festigkeit des Supraleiterdrahtes beitragen kann.

### Hexagonalelemente

In einem erfindungsgemäßen Supraleiterdraht werden Hexagonalelemente eingesetzt, die meist gebündelt in den Supraleiterdraht eingebracht werden; typischerweise wird der Supraleiterdraht nach dem Einbringen der Hexagonalelemente (und ggf. weiterer Strukturen) noch einmal gezogen.

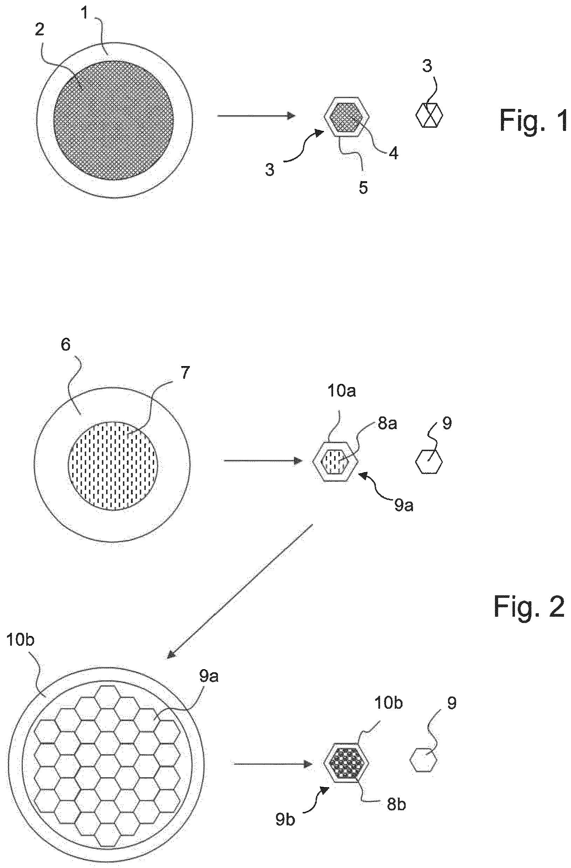

Zumindest ein Teil der Hexagonalelemente in einem erfindungsgemäßen Supraleiterdraht ist als Cu-Al-Verbundelemente ausgebildet. Die typische Herstellung eines Cu-Al-Verbundelements illustriert **Fig. 1****.**

In ein rundes Kupferrohr 1 wird ein runder Aluminiumstab 2 eingeführt (Rohr 1 und Stab 2 erstrecken sich senkrecht zur Bildebene in Fig. 1, die wie auch die nachfolgenden Figuren den Querschnitt illustriert). Anschließend wird der Verbund gezogen, wodurch eine Verringerung des Querschnitts auftritt. Gleichzeitig wird ein hexagonales Querschnittsprofil aufgeprägt. Das entstandene Cu-Al-Verbundelement 3 weist dann einen Al-Kern 4 und einen diesen (im Querschnitt) vollständig umgebenden Cu-Mantel 5 auf, die beide einen hexagonalen (äußeren) Querschnitt aufweisen. In den folgenden Figuren sind Cu-Al-Verbundelemente 3 vereinfacht als Sechseck mit einem Kreuz X dargestellt (siehe rechte Abbildung in Fig. 1).

Neben der zu Fig. 1 erläuterten Aufziehtechnik kann ein Cu-Al-Verbundelement auch z. B. über Strangpressen hergestellt werden.

In vielen Ausführungsformen der Erfindung werden auch NbTi-Elemente eingesetzt. NbTi-Elemente besitzen ebenfalls einen hexagonalen Querschnitt und enthalten ein oder mehrere NbTi-Filamente.

**Fig. 2** illustriert die typische Herstellung von NbTi-Elementen. In eine runde Cu-Hülle 6 wird ein NbTi-Stab 7 eingefügt. Bei einem anschließenden Ziehprozess wird der Querschnitt verringert und ein hexagonales Profil aufgeprägt. Dadurch wird ein einfaches NbTi-Element 9a, mit einem NbTi-Filament 8a und einer Cu-Hülle 10a erhalten.

Falls gewünscht, können mehrere solche NbTi-Elemente 9a gebündelt werden und in einer weiterenrunden Cu-Hülle 10b angeordnet werden. Durch einen Ziehprozess kann wiederum der Querschnitt verringert und ein hexagonales Profil aufgeprägt werden, so dass ein NbTi-Element 9b enthaltend mehrere (hier 37) NbTi-Filamente 8b in einer Cu-Hülle 10b erhalten wird.

NbTi-Elemente beiden Typs 9a, 9b werden in den nachfolgenden Figuren vereinfacht als leeres Sechseck 9 dargestellt (siehe Fig. 2, jeweils rechts).

### Ausführungsformen von erfindungsgemäßen Supraleiterdrähten

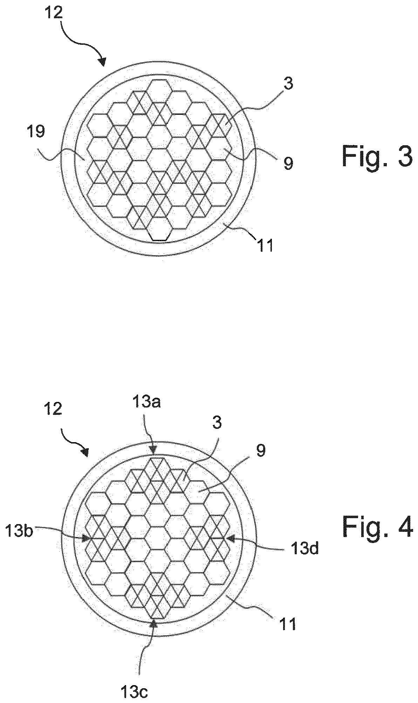

**Fig. 3** zeigt eine einfache Bauform eines Supraleiterdrahtes 12 zur allgemeinen Erläuterung, bei der Cu-Al-Verbundelemente 3 und NbTi-Elemente 9 zufällig gemischt in einem äußeren Cu-Hüllrohr 11 angeordnet sind. Die NbTi-Elemente 9 tragen die Supraleitung, während die Cu-Al-Verbundelemente 3 und das Cu-Hüllrohr 11 deren Stabilisierung bereitstellen. Zur Vermeidung von Hohlräumen können Cu-Füllplatten 19 zwischen dem Cu-Hüllrohr 11 und den Hexagonalelementen (Cu-Al-Verbundelemente 3 und NbTi-Elemente 9) eingesetzt werden.

In **Fig. 4** ist eine Bauform eines Supraleiterdrahtes 12 zur allgemeinen Erläuterung dargestellt, bei der die Cu-Al-Verbundelemente in vier Cu-Al-Clustern 13a-13d gruppiert sind. Innerhalb eines jeden Clusters 13a-13d grenzen die Cu-Al-Verbundelemente 3 des Clusters aneinander, so dass jedes Cu-Al-Verbundelement innerhalb des Clusters mit jedem anderen Cu-Al-Verbundelement des Clusters direkt oder über andere Cu-Al-Verbundelemente des Clusters verbunden ist. Die Cluster 13a-13d sind voneinander separat, also nicht aneinander grenzend, angeordnet (sie sind insbesondere auch nicht über Cu-Al-Verbindungselemente miteinander verbunden), und werden durch NbTi-Elemente 9 voneinander getrennt. Die Cu-Al-Cluster 13a-13d sind dabei auch in azimutaler Richtung (Umfangsrichtung) beabstandet, so dass die Cluster 13a-13d auch als Cu-Al-Sektoren bezeichnet werden können. Durch die Clusteranordnung werden Bereiche mit Umformungsspannungen klein gehalten.

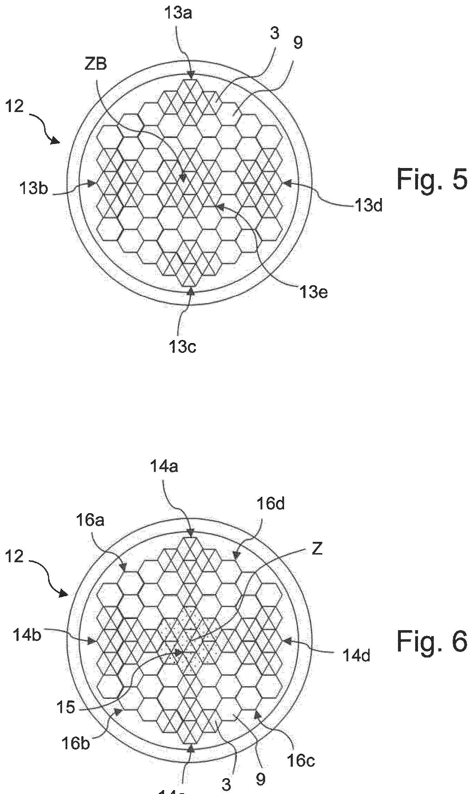

In der Bauform eines Supraleiterdrahtes 12 zur allgemeinen Erläuterung von **Fig. 5** sind ebenfalls vier Cu-Al-Cluster 13a-13d wie in der vorhergehenden Ausführungsform vorgesehen, und zusätzlich noch in einem Zentralbereich ZB ein weiterer Cu-Al-Cluster 13e. Die Cu-Al-Cluster 13a-13e sind wiederum separat angeordnet und werden von NbTi-Elementen 9 voneinander getrennt.

In **Fig. 6** umfasst die Bauform eines Supraleiterdrahtes 12 zur allgemeinen Erläuterung vier Cu-Al-Sektoren 14a-14d, die aus aneinander grenzenden Cu-Al-Verbundelementen 3 aufgebaut sind. Die Cu-Al-Sektoren 14a-14d werden in azimutaler Richtung durch NbTi-Sektoren 16a-16d voneinander getrennt, die aus aneinander grenzenden NbTi-Elementen 9 aufgebaut sind. Weiterhin ist ein Cu-Al-Zentralsektor 15 vorgesehen, der an jeden der Cu-Al-Sektoren 14a-14d angrenzt. Der Cu-Al-Zentralsektor 15 übergreift auch das Zentrum Z des Supraleiterdrahtes 12. Zur besseren Kenntlichmachung ist der Cu-Al-Zentralsektor 15 gepunktet dargestellt.

Innerhalb eines jeden Sektors 14a-14d, 15 grenzen die Cu-Al-Verbundelemente 3 des Sektors aneinander, so dass jedes Cu-Al-Verbundelement innerhalb des Sektors mit jedem anderen Cu-Al-Verbundelement des Sektors direkt oder über andere Cu-Al-Verbundelemente des Sektors verbunden ist. Innerhalb eines jeden Sektors 16a-16d grenzen die NbTi-Elemente 9 des Sektors aneinander, so dass jedes NbTi-Element innerhalb des Sektors mit jedem anderen NbTi-Element des Sektors direkt oder über andere NbTi-Elemente des Sektors verbunden ist. Man beachte, dass die NbTi-Sektoren 16a-16d auch als NbTi-Cluster bezeichnet werden können, da sie nicht nur in azimutaler Richtung voneinander beabstandet sind, sondern vollständig voneinander separiert sind (und nicht über NbTi-Elemente miteinander verbunden sind). Durch die Sektoranordnung werden ebenfalls Bereiche mit Umformungsspannungen klein gehalten.

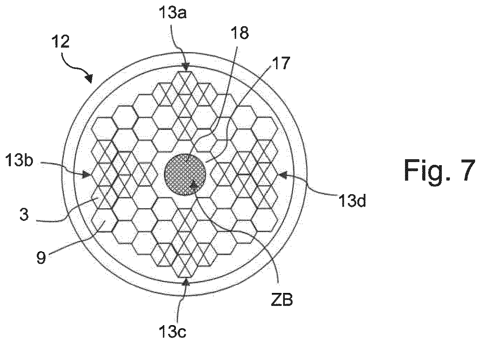

In der **Fig. 7** ist eine weitere Bauform eines Supraleiterdrahts 12 zur allgemeinen Erläuterung dargestellt. Dieser umfasst vier Cu-Al-Cluster 13a-13d von aneinander grenzenden Cu-Al-Verbundelementen 3. Die Cu-Al-Cluster 13a-13d sind durch NbTi-Elemente 9 (die hier in vier Clustern oder Sektoren gruppiert sind) und ein Cu-Profilrohr 17 voneinander getrennt (und auch in azimutaler Richtung beabstandet). Das Cu-Profilrohr 17, welches einen Zentralbereich ZB des Supraleiterdrahtes 12 begrenzt, weist einen runden Al-Kern 18 auf und ist außenseitig so profiliert, dass die umgebenden Hexagonalelemente (Cu-Al-Verbundelemente 3 und die NbTi-Elemente 9) in dichter Packung angrenzend angeordnet werden können. Man beachte, dass das Cu-Profilrohr 17 an alle vier Cu-Al-Cluster 13a-13d angrenzt.

Der AI-Kern 18 und das Profilrohr 17 sollten nicht zu groß gewählt werden, um einen Aufbau von Umformungsspannungen zu vermeiden bzw. diese gering zu halten.

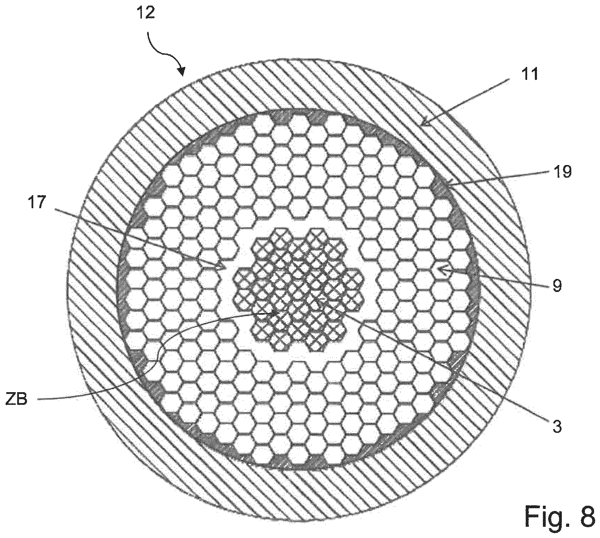

Zur Ausbildung eines größeren, Aluminium enthaltenden Zentralbereichs ZB kann wie in einer Bauform eines Supraleiterdrahts 12 von **Fig. 8** zur allgemeinen Erläuterung dargestellt ein innenseitig und außenseitig profiliertes Cu-Profilrohr 17 eingesetzt werden. Im Profilrohr 17 ist sind Cu-Al-Verbundelemente 3 angeordnet, wodurch ein Cu-Al-Zentralcluster gebildet wird, welches von den weiter außen liegenden NbTi-Elementen 9 durch das Profilrohr 17 getrennt wird. Durch die Anordnung des AI-Materials in den Cu-Al-Verbundelementen 3 bauen sich im Zentralbereich ZB, der durch das Cu-Profilrohr 17 begrenzt wird, nur geringe, nicht zu einer Rissbildung führende Umformspannungen auf.

Außerhalb des Profilrohrs 17 sind in der gezeigten Bauform keine Cu-Al-Verbundelemente angeordnet; alternativ könnten jedoch auch Cu-Al-Verbundelemente 3 außerhalb des Profilrohrs 17 vorgesehen sein, etwa gruppiert in Cu-Al-Clustern.

Der Supraleiterdraht 12 verfügt hier über ein Cu-Hüllrohr 11, an dessen Innenseite Cu-Füllplatten 19 (dunkel schraffiert dargestellt) angelegt sind, um die NbTi-Elemente 9 definiert und kompakt zu halten. Das Cu-Hüllrohr 11 und das Cu-Profilrohr 17 verleihen dem Supraleiterdraht 12 eine gute mechanische Stabilität. Das Profilrohr 17 erleichtert auch den Bündelungsprozess bei der Drahtherstellung.

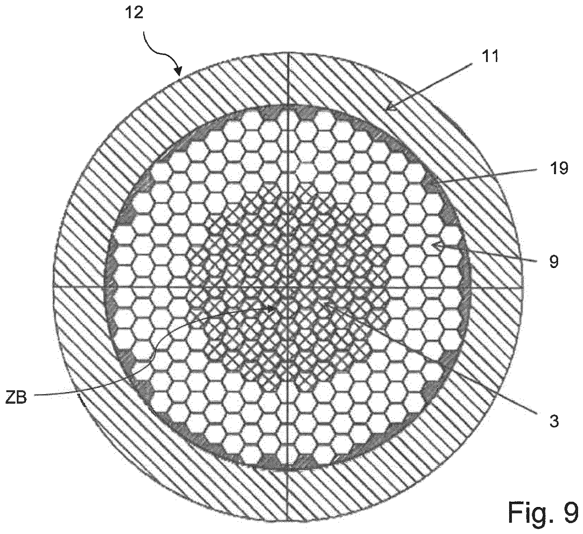

Wie in **Fig. 9** zur allgemeinen Erläuterung gezeigt ist es alternativ auch möglich, bei einer anderen Bauform eines Supraleiterdrahts 12 in einem Zentralbereich ZB Cu-Al-Verbundelemente 3 anzuordnen, ohne ein Profilrohr vorzusehen. NbTi-Verbundelemente 9 grenzen dann direkt an den Cu-Al-Zentralcluster, der durch die Cu-Al-Verbundelemente 3 gebildet wird, an.

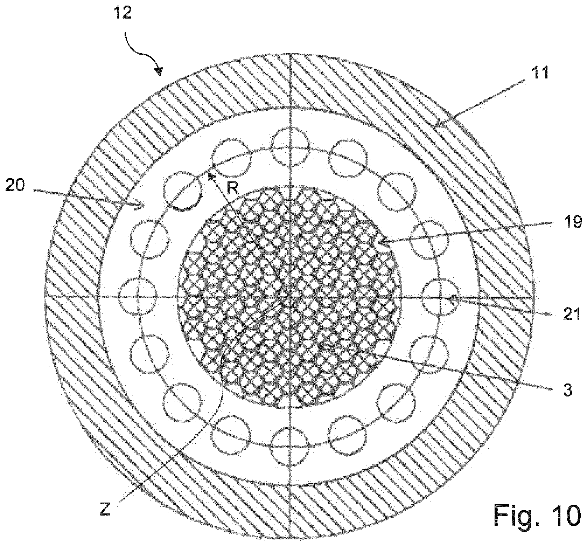

**Fig. 10** zeigt eine erste Ausführungsform eines erfindungsgemäßen Supraleiterdrahts 12, umfassend eine Cu-Hülse 20 mit Tieflochbohrungen für NbTi-Unterstrukturen 21, hier NbTi-Stäbe. Ein NbTi-Stab stellt im Supraleiterdraht 12 einen einzelnen supraleitenden Strompfad - also ein einzelnes NbTi-Filament - zur Verfügung; alternativ kann als NbTi-Unterstruktur auch eine Multifilament-Unterstruktur vorgesehen sein, beispielsweise umfassend eine Cu-Matrix mit mehreren, typischerweise neunzehn oder mehr, eingebetteten NbTi-Filamenten. Die Cu-Hülse 20 ist hier umgeben von einem Cu-Hüllrohr 11, so dass die Cu-Hülse 20 auch als eine Zwischenhülse bezeichnet werden kann. Innerhalb (in der zentralen Bohrung) der Cu-Hülse 20 sind Cu-Al-Verbundelemente 3 angeordnet; etwaige Hohlräume am Rand können mit Cu-Füllplatten 19 aufgefüllt werden.

Die NbTi-Unterstrukturen 21 sind hier in azimutaler Richtung gleichmäßig in der Cu-Hülse 20 verteilt angeordnet, und liegen alle auf demselben radialen Abstand (Radius) R vom Zentrum Z des Supraleiterdrahtes 12. Durch die Verwendung von Cu-Al-Verbundelementen 3 im Zentralbereich ZB des Supraleiterdrahtes 12 kann deutlich Gewicht eingespart werden.

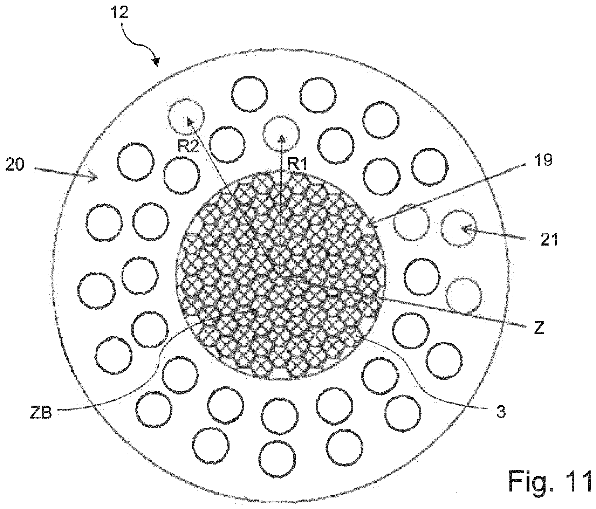

Die in **Fig. 11** gezeigte zweite Ausführungsform eines erfindungsgemäßen Supraleiterdrahtes 12 ist ohne ein Cu-Hüllrohr ausgebildet; die Cu-Hülse 20 begrenzt hier den Supraleiterdraht 12 unmittelbar nach außen. In der Cu-Hülse 20 sind verteilt auf zwei radiale Abstände (Radien) R1, R2 wiederum Tieflochbohrungen für NbTi-Unterstrukturen 21 vorgesehen. Die NbTi-Unterstrukturen 21 sind in azimutaler Richtung auf beiden radialen Abständen R1, R2 gleichmäßig verteilt angeordnet. Im Zentralbereich ZB des Supraleiterdrahtes sind Cu-Al-Verbundelemente 3 angeordnet.

Zusammenfassend beschreibt die Erfindung NbTi-Supraleiterdrähte, bei denen sowohl Aluminium als auch Kupfer zur Stabilisierung von NbTi-Supraleiterfilamenten eingesetzt werden. Das Aluminium ist dabei in im Querschnitt hexagonalen Cu-Al-Verbundelementen angeordnet, die einen AI-Kern und einen Cu-Mantel aufweisen. Bevorzugt ist Aluminium ausschließlich in Cu-Al-Verbundelementen vorgesehen. In den einzelnen Verbundelementen können sich allenfalls geringe Umformspannungen aufbauen, so dass bei Drahtziehprozessen, die zur Herstellung des Supraleiterdrahtes nötig sind, eine Rissbildung vermieden wird. Zusätzlich können die Cu-Al-Verbundelemente innerhalb des Supraleiterdrahtes gruppiert werden, so dass in Umfangsrichtung die Anordnung von Cu-Al-Verbundelementen regelmäßig unterbrochen ist, etwa durch NbTi-Sektoren aus NbTi-Elementen. Dadurch werden Umformspannungen weiter reduziert.

## Patentansprüche

1. Supraleiterdraht (12), enthaltend NbTi-Supraleitermaterial und Cu, umfassend eine Vielzahl von Hexagonalelementen, die im Querschnitt senkrecht zur Erstreckungsrichtung des Supraleiterdrahtes (12) eine zumindest näherungsweise hexagonale Außenkontur aufweisen,
**dadurch gekennzeichnet,**
**dass** zumindest ein Teil der Hexagonalelemente als Cu-Al-Verbundelemente (3) ausgebildet ist, wobei die Cu-Al-Verbundelemente (3) im Querschnitt senkrecht zur Erstreckungsrichtung des Supraleiterdrahtes (12) jeweils ausgebildet sind mit einem Al-Kern (4) und einem Cu-Mantel (5), der den Al-Kern (4) umhüllt, und dass der Supraleiterdraht (12) eine Hülse, insbesondere Cu-Hülse (20), aufweist, in die mehrere voneinander separate NbTi-Unterstrukturen (21) eingebettet sind, wobei jede NbTi-Unterstruktur (21) ein oder mehrere NbTi-Filamente aufweist.

2. Supraleiterdraht (12) nach Anspruch 1, **dadurch gekennzeichnet, dass** der Supraleiterdraht (12) im Querschnitt senkrecht zur Erstreckungsrichtung des Supraleiterdrahtes (12) zumindest drei Cu-Al-Sektoren (14a-14d) aufweist, wobei jeder Cu-Al-Sektor (14a-14d) eine Vielzahl von aneinander grenzenden Cu-Al-Verbundelementen (3) aufweist, und wobei die Cu-Al-Sektoren (14a-14d) azimutal voneinander beabstandet sind,
insbesondere wobei die Cu-Al-Sektoren (14a-14d) azimutal gleichmäßig verteilt angeordnet sind.

3. Supraleiterdraht (12) nach Anspruch 2, **dadurch gekennzeichnet, dass** die zumindest drei Cu-Al-Sektoren (14a-14d) an einen Cu-Al-Zentralsektor (15) angrenzen, der eine Vielzahl von aneinander grenzenden Cu-Al-Verbundelementen (3) aufweist und der im Querschnitt senkrecht zur Erstreckungsrichtung des Supraleiterdrahtes (12) im Zentrum (Z) des Supraleiterdrahtes (12) angeordnet ist.

4. Supraleiterdraht (12) nach einem der vorhergehenden Ansprüche, **dadurch gekennzeichnet, dass** der Supraleiterdraht (12) im Querschnitt senkrecht zur Erstreckungsrichtung des Supraleiterdrahtes (12) wenigstens drei voneinander separate Cu-Al-Cluster (13a-13e) aufweist, wobei jeder Cu-Al-Cluster (13a-13e) eine Vielzahl von aneinander grenzenden Cu-Al-Verbundelementen (3) aufweist.

5. Supraleiterdraht (12) nach einem der vorhergehenden Ansprüche, **dadurch gekennzeichnet, dass** ein Teil der Hexagonalelemente als NbTi-Elemente (9, 9a, 9b) ausgebildet ist, wobei die NbTi-Elemente (9, 9a, 9b) jeweils ein oder mehrere NbTi-Filamente (8a, 8b) aufweisen.

6. Supraleiterdraht (12) nach Anspruch 5, **dadurch gekennzeichnet, dass** die NbTi-Elemente (9, 9a, 9b) jeweils eine Cu-Matrix und/oder eine Cu-Hülle (10a, 10b) aufweisen.

7. Supraleiterdraht (12) nach Anspruch 5 oder 6, **dadurch gekennzeichnet, dass** der Supraleiterdraht (12) im Querschnitt senkrecht zur Erstreckungsrichtung des Supraleiterdrahtes (12) wenigstens drei NbTi-Sektoren (16a-16d) aufweist, wobei jeder NbTi-Sektor (16a-16d) eine Vielzahl von aneinander grenzenden NbTi-Elementen (9, 9a, 9b) aufweist, und wobei die NbTi-Sektoren (16a-16d) azimutal voneinander beabstandet sind.

8. Supraleiterdraht (12) nach einem der vorhergehenden Ansprüche, **dadurch gekennzeichnet, dass** der Supraleiterdraht (12) im Querschnitt senkrecht zur Erstreckungsrichtung des Supraleiterdrahtes (12) einen Zentralbereich (ZB) aufweist, der Al enthält.

9. Supraleiterdraht (12) nach Anspruch 8, **dadurch gekennzeichnet, dass** der Zentralbereich (ZB) eine Vielzahl von aneinander angrenzenden Cu-Al-Verbundelementen (3) aufweist.

10. Supraleiterdraht (12) nach Anspruch 8 oder 9, **dadurch gekennzeichnet, dass** ein Profilrohr, insbesondere ein Cu-Profilrohr (17), den Zentralbereich (ZB) begrenzt.

11. Supraleiterdraht (12) nach einem der vorhergehenden Ansprüche, **dadurch gekennzeichnet, dass** die NbTi-Unterstrukturen (21) azimutal gleichmäßig verteilt angeordnet sind.

12. Supraleiterdraht (12) nach einem der vorhergehenden Ansprüche, **dadurch gekennzeichnet, dass** die NbTi-Unterstrukturen (21) einen gleichen radialen Abstand (R) zum Zentrum (Z) des Supraleiterdrahtes (12) haben.

13. Supraleiterdraht (12) nach einem der vorhergehenden Ansprüche, **dadurch gekennzeichnet, dass** die NbTi-Unterstrukturen (21) auf zwei oder mehr radiale Abstände (R1, R2) verteilt sind, wobei jeweils sechs oder mehr NbTi-Unterstrukturen (21) den gleichen radialen Abstand (R1, R2) zum Zentrum (Z) des Supraleiterdrahts (12) haben.

14. Supraleiterdraht (12) nach einem der vorhergehenden Ansprüche, **dadurch gekennzeichnet, dass** der Supraleiterdraht (12) ein äußeres Hüllrohr umfasst, insbesondere ein Cu-Hüllrohr (11).

## Claims

1. Superconducting wire (12), containing NbTi superconducting material and Cu, comprising a plurality of hexagonal elements having an at least approximately hexagonal outer contour in a cross-section perpendicular to a direction of extension of the superconducting wire (12),
**characterized in that**
at least a portion of the hexagonal elements is configured as Cu-AI composite elements (3), wherein the Cu-AI composite elements (3), in a cross-section perpendicular to a direction of extension of the superconducting wire (12), are each configured with an Al core (4) and a Cu sheath (5) that surrounds the Al core (4), and that the superconducting wire (12) comprises a sleeve, in particular a Cu sleeve (20), in which is embedded a plurality of mutually separated NbTi substructures (21), wherein each NbTi substructure (21) comprises one or a plurality of NbTi filaments.

2. Superconducting wire (12) according to claim 1, **characterized in that** the superconducting wire (12), in a cross-section perpendicular to a direction of extension of the superconducting wire (12), has at least three Cu-AI sectors (14a-14d), wherein each Cu-AI sector (14a-14d) comprises a plurality of contiguous Cu-AI composite elements (3), and wherein the Cu-AI sectors (14a-14d) are azimuthally spaced from one another, in particular wherein the Cu-Al sectors (14a-14d) are arranged in an azimuthally evenly distributed manner.

3. Superconducting wire (12) according to claim 2, **characterized in that** the at least three Cu-Al sectors (14a-14d) are adjacent to a Cu-Al central sector (15) which comprises a plurality of contiguous Cu-Al composite elements (3) and which, in a cross-section perpendicular to a direction of extension of the superconducting wire (12), is arranged in the centre (Z) of the superconducting wire (12).

4. Superconducting wire (12) according to any one of the preceding claims, **characterized in that** the superconducting wire (12), in a cross-section perpendicular to a direction of extension of the superconducting wire (12), comprises at least three mutually separated Cu-Al clusters (13a-13e), wherein each Cu-Al cluster (13a-13e) comprises a plurality of contiguous Cu-Al composite elements (3).

5. Superconducting wire (12) according to any one of the preceding claims, **characterized in that** a portion of the hexagonal elements is configured as NbTi elements (9, 9a, 9b), wherein each of the NbTi elements (9, 9a, 9b) comprises one or a plurality of NbTi filaments (8a, 8b).

6. Superconducting wire (12) according to claim 5, **characterized in that** each of the NbTi elements (9, 9a, 9b) comprises a Cu matrix and/or a Cu cladding (10a, 10b).

7. Superconducting wire (12) according to claim 5 or 6, **characterized in that** the superconducting wire (12), in a cross-section perpendicular to a direction of extension of the superconducting wire (12), comprises at least three NbTi sectors (16a-16d), wherein each NbTi sector (16a-16d) comprises a plurality of contiguous NbTi elements (9, 9a, 9b), and wherein the NbTi sectors (16a-16d) are azimuthally spaced from one another.

8. Superconducting wire (12) according to one of the preceding claims, **characterized in that** the superconducting wire (12), in a cross-section perpendicular to a direction of extension of the superconducting wire (12), comprises a central area (ZB) that contains Al.

9. Superconducting wire (12) according to claim 8, **characterized in that** the central area (ZB) comprises a plurality of contiguous Cu-Al composite elements (3).

10. Superconducting wire (12) according to claim 8 or 9, **characterized in that** a profile tube, in particular a Cu profile tube (17), delimits the central area (ZB).

11. Superconducting wire (12) according to any one of the preceding claims, **characterized in that** the NbTi substructures (21) are arranged in an azimuthally evenly distributed manner.

12. Superconducting wire (12) according to any one of the preceding claims, **characterized in that** the NbTi substructures (21) are arranged at the same radial distance (R) from the centre (Z) of the superconducting wire (12).

13. Superconducting wire (12) according to any one of the preceding claims, **characterized in that** the NbTi substructures (21) are distributed at two or more radial distances (R1, R2), wherein six or more NbTi substructures (21) are each at the same radial distance (R1, R2) from the centre (Z) of the superconducting wire (12).

14. Superconducting wire (12) according to any one of the preceding claims, **characterized in that** the superconducting wire (12) comprises an outer cladding tube, in particular a Cu cladding tube (11).

## Revendications

1. Fil supraconducteur (12) contenant un matériau supraconducteur NbTi et du Cu, comprenant une pluralité d'éléments hexagonaux lesquels présentent, en section transversale perpendiculairement à la direction d'extension du fil supraconducteur (12), un contour extérieur au moins approximativement hexagonal,
**caractérisé en ce**
**qu'**au moins une partie des éléments hexagonaux sont réalisés en tant qu'éléments composites en Cu-Al (3), dans lequel les éléments composites en Cu-Al (3) sont réalisés, en section transversale perpendiculairement à la direction d'extension du fil supraconducteur (12), respectivement avec une âme en Al (4) et une enveloppe en Cu (5) qui enveloppe l'âme en Al (4), et que le fil supraconducteur (12) présente une gaine, en particulier une gaine en Cu (20) dans laquelle plusieurs sous-structures NbTi (21) séparées les unes des autres sont noyées, dans lequel chaque sous-structure NbTi (21) présente un ou plusieurs filaments NbTi.

2. Fil supraconducteur (12) selon la revendication 1, **caractérisé en ce que** le fil supraconducteur (12) présente, en section transversale perpendiculairement à la direction d'extension du fil supraconducteur (12), au moins trois secteurs en Cu-Al (14a-14d), dans lequel chaque secteur en Cu-Al (14a-14d) présente une pluralité d'éléments composites en Cu-Al (3) adjacents entre eux, et dans lequel les secteurs en Cu-Al (14a-14d) sont espacés azimutalement les uns des autres,
dans lequel les secteurs en Cu-Al (14a-14d) sont en particulier disposés azimutalement de façon régulièrement répartie.

3. Fil supraconducteur (12) selon la revendication 2, **caractérisé en ce que** les au moins trois secteurs en Cu-Al (14a-14d) sont adjacents d'un secteur central en Cu-Al (15) qui présente une pluralité d'éléments composites en Cu-Al (3) adjacents entre eux et qui est disposé, en section transversale perpendiculairement à la direction d'extension du fil supraconducteur (12), au centre (Z) du fil supraconducteur (12).

4. Fil supraconducteur (12) selon l'une des revendications précédentes, **caractérisé en ce que** le fil supraconducteur (12) présente, en section transversale perpendiculairement à la direction d'extension du fil supraconducteur (12), au moins trois clusters en Cu-Al (13a-13e) séparés les uns des autres, dans lequel chaque cluster en Cu-Al (13a-13e) présente une pluralité d'éléments composites en Cu-Al (3) adjacents entre eux.

5. Fil supraconducteur (12) selon l'une des revendications précédentes, **caractérisé en ce qu'**une partie des éléments hexagonaux est réalisée en tant qu'éléments NbTi (9, 9a, 9b), dans lequel les éléments NbTi (9, 9a, 9b) présentent respectivement un ou plusieurs filaments NbTi (8a, 8b).

6. Fil supraconducteur (12) selon la revendication 5, **caractérisé en ce que** les éléments NbTi (9, 9a, 9b) présentent respectivement une matrice en Cu et/ou une enveloppe en Cu (10a, 10b).

7. Fil supraconducteur (12) selon la revendication 5 ou 6, **caractérisé en ce que** le fil supraconducteur (12) présente, en section transversale perpendiculairement à la direction d'extension du fil supraconducteur (12), au moins trois secteurs NbTi (16a-16d), dans lequel chaque secteur NbTi (16a-16d) présente une pluralité d'éléments NbTi (9, 9a, 9b) adjacents entre eux, et dans lequel les secteurs NbTi (16a-16d) sont espacés azimutalement les uns des autres.

8. Fil supraconducteur (12) selon l'une des revendications précédentes, **caractérisé en ce que** le fil supraconducteur (12) présente, en section transversale perpendiculairement à la direction d'extension du fil supraconducteur (12), une zone centrale (ZB) qui contient de l'Al.

9. Fil supraconducteur (12) selon la revendication 8, **caractérisé en ce que** la zone centrale (ZB) présente une pluralité d'éléments composites en Cu-Al (3) adjacents entre eux.

10. Fil supraconducteur (12) selon la revendication 8 ou 9, **caractérisé en ce qu'**un tuyau profilé, en particulier un tuyau profilé en Cu (17), délimite la zone centrale (ZB).

11. Fil supraconducteur (12) selon l'une des revendications précédentes, **caractérisé en ce que** les sous-structures NbTi (21) sont disposées azimutalement de façon régulièrement répartie.

12. Fil supraconducteur (12) selon l'une des revendications précédentes, **caractérisé en ce que** les sous-structures NbTi (21) ont une même distance radiale (R) par rapport au centre (Z) du fil supraconducteur (12).

13. Fil supraconducteur (12) selon l'une des revendications précédentes, **caractérisé en ce que** les sous-structures NbTi (21) sont réparties sur deux ou davantage de distances radiales (R1, R2), dans lequel respectivement six ou davantage de sous-structures NbTi (21) ont la même distance radiale (R1, R2) par rapport au centre (Z) du fil supraconducteur (12).

14. Fil supraconducteur (12) selon l'une des revendications précédentes, **caractérisé en ce que** le fil supraconducteur (12) comprend un tube de gainage extérieur, en particulier un tube de gainage en Cu (11).
